(19) Europäisches Patentamt / European Patent Office / Office européen des brevets

(11) **EP 4 276 480 B1**

(12) **EUROPÄISCHE PATENTSCHRIFT**

(45) Veröffentlichungstag und Bekanntmachung des Hinweises auf die Patenterteilung:
**17.12.2025 Patentblatt 2025/51**

(21) Anmeldenummer: **22172506.2**

(22) Anmeldetag: **10.05.2022**

(51) Internationale Patentklassifikation (IPC):
**G01R 31/08** (2020.01)   **H02H 3/16** (2006.01)
**H02H 3/38** (2006.01)

(52) Gemeinsame Patentklassifikation (CPC):
**G01R 31/088; H02H 3/405;** G01R 19/2513;
G01R 31/085; H02H 3/165

(54) **VERFAHREN UND SCHUTZGERÄT ZUM ERKENNEN EINES EINPHASIGEN ERDSCHLUSSES**

METHOD AND DEVICE FOR DETECTING A SINGLE PHASE GROUND FAULT

PROCÉDÉ ET APPAREIL DE PROTECTION PERMETTANT DE DÉTECTER UN RACCORDEMENT À LA TERRE MONOPHASÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.11.2023 Patentblatt 2023/46**

(73) Patentinhaber: **Siemens Aktiengesellschaft 80333 München (DE)**

(72) Erfinder:
• **Cox, Benjamin**
**Wien (AT)**
• **Gawlik, Wolfgang**
**Wien (AT)**

(74) Vertreter: **Siemens Patent Attorneys Postfach 22 16 34 80506 München (DE)**

(56) Entgegenhaltungen:
EP-A2- 2 738 561    WO-A1-03/044547
DE-T2- 60 317 344

• WASHER MARIE ET AL: "Precise impedance based fault location algorithm with fault resistance separation", 2015 IEEE EINDHOVEN POWERTECH, IEEE, 29 June 2015 (2015-06-29), pages 1 - 6, XP033215617, DOI: 10.1109/ PTC.2015.7232595

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zum Erkennen eines einphasigen Erdschlusses eines elektrischen Phasenleiters in einem Leitungsabschnitt einer dreiphasigen elektrischen Energieübertragungsleitung, wobei bei dem Verfahren an einer an einem Abschnittsende des Leitungsabschnitts befindlichen Messstelle für den Phasenleiter Phasenstrom und Phase-Erde-Spannung unter Bildung eines Phasenstromzeigers und eines Phasenspannungszeigers gemessen werden, unter Berücksichtigung des Phasenstromzeigers und des Phasenspannungszeigers und eines Kompensationsstromzeigers eine Fehlerimpedanz errechnet wird und anhand der Fehlerimpedanz auf das Vorliegen oder Nichtvorliegen eines Erdschlusses des Phasenleiters geschlossen wird.

Ein solches Verfahren ist beispielsweise in der Veröffentlichungsschrift "Precise Impedance Based Fault Location Algorithm with Fault Resistance Separation" (Marie Washer and Jean-Claude Maun, École polytechnique de Bruxelles, Université Libre de Bruxelles, Brussels, Belgium; Cezary Dzienis, Matthias Kereit, Yilmaz Yelgin and Joerg Blumschein, EM EA PRO D, Siemens AG Berlin, Germany) offenbart.

Die DE 603 17 344 T2 offenbart ein Verfahren zum Lokalisieren eines Kurzschlusses, wobei so genannte Shunt-Kapazitäten kompensiert werden. Dieser Kompensationsvorgang erfordert iterative Berechnungen. Bei der ersten Iteration wird ein Kompensationsstromzeiger definiert, dessen Berechnung auf dem Ableiten des Shunt-Stromes von dem positiven Sequenzstrom basiert.

Weiterer Stand der Technik ist in der EP 2 738 561 A2 und der WO O3/044547 A1 offenbart.

Der Erfindung liegt die Aufgabe zugrunde, ein Verfahren der oben beschriebenen Art noch weiter zu verbessern.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass der Kompensationsstromzeiger in Abhängigkeit von einem Korrekturwert, dessen Berechnung eine Multiplikation eines die Kapazität des Leitungsabschnitts angebenden Kapazitätswerts und eines Bezugsspannungszeigers einschließt, errechnet wird.

Ein wesentlicher Vorteil des erfindungsgemäßen Verfahrens besteht darin, dass der bereits aus der oben genannten Druckschrift vorbekannte Kompensationsstromzeiger zusätzlich einen Korrekturwert berücksichtigt, der von der Leitungskapazität des Leitungsabschnitts sowie einem sich auf den Leitungsabschnitt beziehenden Spannungszeiger abhängig ist. Durch den zusätzlichen Einbezug von Kapazitätseffekten lassen sich Erdschlussfehler besonders zuverlässig auch bei sehr kleinen Fehlerströmen erkennen.

Vorteilhaft ist es, wenn ein erkannter Erdschluss zusätzlich auch geortet wird, also außerdem die Entfernung eines erkannten Erdschlusses vom Ort der Messung ermittelt wird.

Als besonders vorteilhaft wird es angesehen, wenn die Berechnung des Kompensationsstromzeigers eine Multiplikation des die Kapazität des Leitungsabschnitts angebenden Kapazitätswerts, des Bezugsspannungszeigers und der Drehfrequenz der elektrischen Energieübertragungsleitung einschließt.

Bei einer besonders bevorzugten Ausgestaltung des Verfahrens ist vorgesehen, dass die Fehlererkennung nullsystembezogen erfolgt. Vorteilhaft ist es beispielsweise, wenn auf der Basis der Methode der symmetrischen Komponenten ein den Nullsystemstrom an der Messstelle angebender Nullsystemstromzeiger errechnet wird und der Kompensationsstromzeiger unter Einbezug des Nullsystemstromzeigers errechnet wird.

Der Kompensationsstromzeiger wird nullsystembezogen vorzugsweise durch Subtraktion eines Vielfachen des Korrekturwerts, vorzugsweise dem Dreifachen, von einem Vielfachen, vorzugsweise dem Dreifachen, des Nullsystemstromzeigers errechnet.

Auch ist es von Vorteil, wenn auf der Basis der Methode der symmetrischen Komponenten ein die Nullsystemspannung an der Messstelle angebender Nullsystemspannungszeiger errechnet wird, zur Berechnung des Korrekturwerts als der genannte Kapazitätswert ein die Nullsystemkapazität des Leitungsabschnitts angebender Nullsystemkapazitätswert herangezogen wird und zur Berechnung des Korrekturwerts als der genannte Bezugsspannungszeiger der Nullsystemspannungszeiger herangezogen wird.

Der Korrekturwert wird nullsystembezogen vorzugsweise berechnet gemäß:

$$KW = j\omega \cdot C_{0,L} \cdot \underline{U}_{A,0}$$

wobei $C_{0,L}$ den Nullsystemkapazitätswert des Leitungsabschnitts, KW den Korrekturwert und $\underline{U}_{A,0}$ den Nullsystemspannungszeiger bezeichnet.

Der Kompensationsstromzeiger wird nullsystembezogen vorzugsweise berechnet gemäß:

$$\underline{I}_{A,Cmp} = 3 \cdot (\underline{I}_{A,O} - j\omega \cdot C_{0,L} \cdot \underline{U}_{A,0})$$

wobei $\underline{I}_{A,Cmp}$ den Kompensationsstromzeiger, $\underline{I}_{A,0}$ den Nullsystemstromzeiger an der Messstelle, $C_{0,L}$ den Nullsystemkapazitätswert des Leitungsabschnitts, KW den Korrekturwert und $\underline{U}_{A,0}$ den Nullsystemspannungszeiger bezeichnet.

Auch ist es von Vorteil, wenn ein Kompensationsfaktor errechnet wird gemäß

$$\underline{\delta}_{A,B} = \left( \frac{\underline{Z}_{A,0} + m \cdot \underline{Z}_{L,0}}{(1-m) \cdot \underline{Z}_{L,0} + \underline{Z}_{B,0}} + 1 \right)$$

wobei $\underline{\delta}_{A,B}$ den Kompensationsfaktor, $\underline{Z}_{A,0}$ die Nullsystemimpedanz des Leitungsabschnitts an der Messstelle, $\underline{Z}_{B,0}$ die Nullsystemimpedanz des Leitungsabschnitts an dem anderen Leitungsende des Leitungsabschnitts und m die für die Berechnung angenommene relative Fehlerentfernung von der Messstelle bezeichnet.

Die eingangs erwähnte Fehlerimpedanz wird vorzugsweise berechnet gemäß

$$\underline{Z}_F = R_F + j\ X_F$$

mit

$$X_F = \frac{\sin\varphi \cdot \mathrm{Im}\!\left[\underline{U}_{A,Ph-E} \cdot I_{A,Cmp}^{*} \cdot \underline{\delta}_{A,B}^{*}\right]}{\mathrm{Im}\!\left[e^{j\varphi} \cdot \left(\underline{I}_{A,Ph} - \underline{k}_0 \cdot \underline{I}_{A,E}\right) \cdot \underline{I}_{A,Cmp}^{*} \cdot \underline{\delta}_{A,B}^{*}\right]}$$

$$R_F = \frac{\mathrm{Im}\!\left[\underline{U}_{A,Ph-E} \cdot e^{-j\varphi} \cdot \left(\underline{I}_{A,Ph} - \underline{k}_0 \cdot \underline{I}_{A,E}\right)^{*}\right]}{\mathrm{Im}\!\left[\underline{I}_{A,Cmp} \cdot \underline{\delta}_{A,B} \cdot e^{-j\varphi} \cdot \underline{I}_{A,Ph}^{*}\right]}$$

wobei $\underline{Z}_F$ die Fehlerimpedanz, $R_F$ den Realteil der Fehlerimpedanz, $X_F$ den Imaginärteil der Fehlerimpedanz, $\varphi$ den Leitungswinkel, $\underline{I}_{A,Cmp}$ den Kompensationsstrom, $\underline{\delta}_{A,B}$ den Kompensationsfaktor, $\underline{U}_{A,Ph-E}$ den Phasenspannungszeiger, $\underline{I}_{A,Ph}$ den Phasenstromzeiger, $\underline{I}_{A,E}$ einen Erdstromzeiger und $\underline{k}_0$ einen Erdkompensationsfaktor bezeichnen.

Der Erdkompensationsfaktor $\underline{k}_0$ kann auch als Erdimpedanzanpassungsfaktor bezeichnet werden und wird beispielsweise berechnet durch Division der komplexen Erdimpedanz $\underline{Z}_E$ durch die komplexe Leitungsimpedanz Z.

Liegt die Fehlerimpedanz Zf vor, so kann in vorteilhafter Weise geprüft werden, ob diese in der komplexen Ebene in einem oder mehreren vorgegebenen Fehlergebieten liegt oder nicht. Ist dies der Fall, so wird auf das Vorliegen eines Erdschlusses des Phasenleiters geschlossen und vorzugsweise ein entsprechendes Fehlersignal erzeugt.

Alternativ oder zusätzlich kann gemäß einer zweiten als besonders vorteilhaft angesehenen Verfahrensvariante die Fehlererkennung gegensystembezogen erfolgen, indem der Kompensationsstromzeiger $\underline{I}_{A,Cmp}$ und der Korrekturwert KW gegensystembezogen berechnet werden.

Bezüglich der zweiten Verfahrensvariante wird es als vorteilhaft angesehen, wenn auf der Basis der Methode der symmetrischen Komponenten ein die Gegensystemspannung an der Messstelle angebender Gegensystemspannungszeiger errechnet wird, zur Berechnung des Korrekturwerts als der genannte Kapazitätswert ein die Gegensystemkapazität des Leitungsabschnitts angebender Gegensystemkapazitätswert herangezogen wird und zur Berechnung des Korrekturwerts als der genannte Bezugsspannungszeiger der Gegensystemspannungszeiger herangezogen wird.

Gegensystembezogen wird der Korrekturwert vorzugsweise berechnet gemäß:

$$KW = j\omega \cdot C_{2,L} \cdot \underline{U}_{A,2}$$

wobei $C_{2,L}$ den Gegensystemkapazitätswert des Leitungsabschnitts, KW den Korrekturwert und $\underline{U}_{A,2}$ den Gegensystemspannungszeiger bezeichnet.

Gegensystembezogen wird der Kompensationsstromzeiger vorzugsweise berechnet gemäß:

$$\underline{I}_{A,Cmp} = 3 \cdot \left( \underline{I}_{A,2} - j\omega \cdot C_{2,L} \cdot \underline{U}_{A,2} \right)$$

wobei $\underline{I}_{A,Cmp}$ den Kompensationsstromzeiger, $\underline{I}_{A,2}$ den Gegensystemstrom an der Messstelle, $C_{2,L}$ den Gegensystemkapazitätswert des Leitungsabschnitts und KW den Korrekturwert bezeichnet.

Gegensystembezogen wird der Kompensationsfaktor vorzugsweise errechnet gemäß

$$\underline{\delta}_{A,B} = \left( \frac{\underline{Z}_{A,2} + m \cdot \underline{Z}_{L,2}}{(1-m) \cdot \underline{Z}_{L,2} + \underline{Z}_{B,2}} + 1 \right)$$

wobei $\underline{\delta}_{A,B}$ den Kompensationsfaktor, $\underline{Z}_{A,2}$ die Gegensystemimpedanz des Leitungsabschnitts an der Messstelle, $\underline{Z}_{B,2}$ die Gegensystemimpedanz des Leitungsabschnitts an dem anderen Leitungsende des Leitungsabschnitts und m die angenommene relative Fehlerentfernung von der Messstelle bezeichnet.

Die gegensystembezogene Berechnung der Fehlerimpedanz kann unter Anwendung der bereits für die nullsystembezogene Berechnung der Fehlerimpedanz genannten Formeln erfolgen, also gemäß

$$\underline{Z}_F = R_F + j\ X_F$$

mit

$$X_F = \frac{\sin\varphi \cdot \text{Im}\left[\underline{U}_{A,Ph-E} \cdot \underline{I}^*_{A,Cmp} \cdot \underline{\delta}^*_{A,B}\right]}{\text{Im}\left[e^{j\varphi} \cdot \left(\underline{I}_{A,Ph} - \underline{k}_0 \cdot \underline{I}_{A,E}\right) \cdot \underline{I}^*_{A,Cmp} \cdot \underline{\delta}^*_{A,B}\right]}$$

$$R_F = \frac{\text{Im}\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\text{Im}\left[\underline{I}_{A,Cmp} \cdot \underline{\delta}_{A,B} \cdot e^{-j\varphi} \cdot \underline{I}^*_{A,Ph}\right]}$$

wobei die entsprechenden gegensystembezogenen Werte in die Formeln eingesetzt werden.

Das beschriebene Verfahren wird vorzugsweise bei dreiphasigen elektrischen Energieübertragungsleitungen eingesetzt, bei denen der Sternpunkt über eine Impedanz, beispielsweise eine Petersenspule, geerdet ist. Im Rahmen der Messung bzw. der Erdschlusserkennung und ggf. Ortung kann zu der Impedanz eine weitere Messimpedanz parallel geschaltet werden, um den Stromfluss zu erhöhen und die Fehlerdetektion zu verbessern. Die Erfindung bezieht sich darüber hinaus auf ein Schutzgerät zum Erkennen eines einphasigen Erdschlusses eines elektrischen Phasenleiters in einem Leitungsabschnitt einer dreiphasigen elektrischen Energieübertragungsleitung, wie es im unabhängigen Anspruch 12 definiert wird.

Ein derartiges Schutzgerät ist unter anderem dazu ausgestaltet, für ein Abschnittsende des Leitungsabschnitts für den Phasenleiter Phasenstrom und Phase-Erde-Spannung unter Bildung eines Phasenstromzeigers und eines Phasenspannungszeigers zu erfassen, unter Berücksichtigung des Phasenstromzeigers und des Phasenspannungszeigers und eines Kompensationsstromzeigers eine Fehlerimpedanz zu errechnen und anhand der Fehlerimpedanz auf das Vorliegen oder Nichtvorliegen eines Erdschlusses des Phasenleiters zu schließen. Ein solches Schutzgerät ergibt sich ebenfalls aus der eingangs genannten Veröffentlichungsschrift "Precise Impedance Based Fault Location Algorith with Fault Resistance Separation".

Erfindungsgemäß ist vorgesehen, dass das Schutzgerät derart ausgestaltet ist, dass es den Kompensationsstromzeiger in Abhängigkeit von einem Korrekturwert errechnet, dessen Berechnung eine Multiplikation eines die Kapazität des Leitungsabschnitts angebenden Kapazitätswerts und eines Bezugsspannungszeigers einschließt.

Bezüglich der Vorteile des erfindungsgemäßen Schutzgeräts und dessen vorteilhafter Ausgestaltungen sei auf die obigen Ausführungen im Zusammenhang mit dem erfindungsgemäßen Verfahren und dessen vorteilhafter Ausgestaltungen verwiesen.

Das Schutzgerät umfasst vorzugsweise eine Recheneinrichtung und einen Speicher. In dem Speicher ist vorzugsweise ein Softwareprogramm bzw. Softwareprogrammprodukt abgespeichert, das bei Ausführung durch die Recheneinrichtung die oben im Zusammenhang mit dem erfindungsgemäßen Verfahren und dessen vorteilhafter Ausgestaltungen beschriebenen Berechnungsschritte ausführt.

Vorteilhaft ist es, wenn das Schutzgerät außerdem dazu ausgestaltet ist, einen erkannten Erdschluss zusätzlich auch zu orten, insbesondere die Entfernung des erkannten Erdschlusses vom Ort der Messung zu ermitteln.

Die Erfindung wird nachfolgend anhand von Ausführungsbeispielen näher erläutert; dabei zeigen beispielhaft

Figur 1     einen Leitungsabschnitt einer dreiphasigen Energieübertragungsleitung, anhand derer beispielhaft Ausführungsbeispiele für erfindungsgemäße Verfahren erläutert werden,

Figur 2     ein Ausführungsbeispiel für ein Ersatzschaltbild, das für die Fehlererkennung herangezogen werden kann,

Figur 3     ein Ausführungsbeispiel für ein erfindungsgemäßes Schutzgerät, und

Figur 4     ein weiteres Ausführungsbeispiel für ein erfindungsgemäßes Schutzgerät.

In den Figuren werden der Übersicht halber für identische oder vergleichbare Komponenten stets dieselben Bezugszeichen verwendet.

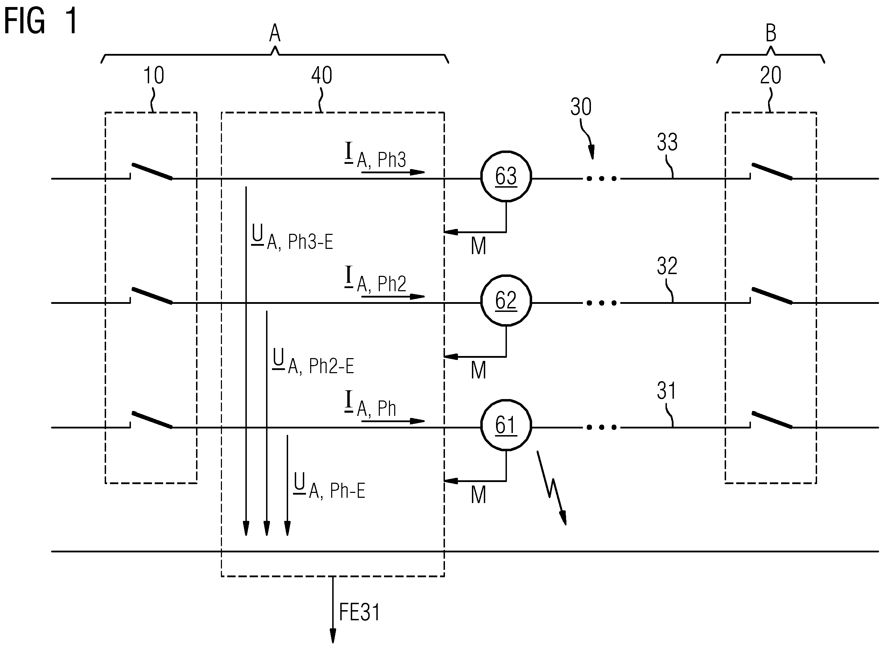

Die Figur 1 zeigt zwei Schalteinrichtungen 10 und 20, die einen Leitungsabschnitt 30 einer dreiphasigen, also drei Phasenleiter 31, 32 und 33 aufweisenden Energieübertragungsleitung begrenzen. Ein nicht gezeigter Sternpunkt der dreiphasigen elektrischen Energieübertragungsleitung ist über eine ebenfalls aus Gründen der Übersicht nicht gezeigte Sternpunktimpedanz, beispielsweise in Form einer Petersenspule, geerdet oder bleibt isoliert.

An einem in der Figur 1 linken Abschnittsende A des Leitungsabschnitts 30 ist ein Schutzgerät 40 über Strom- und Spannungswandler 61, 62 und 63 an die Phasenleiter 31, 32 und 33 des Leitungsabschnitts 30 angeschlossen.

Die Strom- und Spannungswandler 61, 62 und 63 übermitteln Messsignale und/oder Messwerte M, die es dem Schutzgerät 40 ermöglichen, in den Phasenleitern 31, 32 und 33 fließende Ströme bzw. daran anliegende Spannungen messtechnisch zu erfassen. Da bei dem Ausführungsbeispiel gemäß Figur 1 die Strom- und Spannungswandler 61, 62 und 63 an dem linken Abschnittsende A des Leitungsabschnitts 30 angeschlossen sind, bildet dieses linke Abschnittsende A die Messstelle des Schutzgeräts 40.

Die Arbeitsweise des Schutzgeräts 40 soll nachfolgend beispielhaft im Zusammenhang mit dem Erkennen eines einphasigen Erdschlusses eines der Phasenleiter, beispielsweise des in der Figur 1 untersten Phasenleiters 31 erläutert werden. Für die beiden anderen Phasenleiter 32 und 33 kann die Erdschlusserkennung parallel oder zeitlich versetzt in entsprechender bzw. identischer Weise erfolgen.

Unter Heranziehung der mittels der Strom- und Spannungswandler 61, 62 und 63 erfassten Messsignale bzw. Messwerte M berechnet das Schutzgerät 40 zunächst für jeden der Phasenleiter 31, 32 und 33 jeweils einen Phasenstromzeiger und einen Phase-Erde-Spannungszeiger, wie dies im Bereich der Schutztechnik allgemein bekannt und wie es beispielsweise in der eingangs genannten Druckschrift beschrieben ist.

In der Figur 1 ist für den in der Figur 1 untersten Phasenleiter 31 der Phasenstromzeiger mit dem Bezugszeichen $\underline{I}_{A,Ph}$ und der Phase-Erde-Spannungszeiger mit dem Bezugszeichen $\underline{U}_{A,Ph-E}$ gekennzeichnet. Für die beiden anderen Phasenleiter 32 und 33 sind die Phasenstromzeiger mit den Bezugszeichen $\underline{I}_{A,Ph2}$ bzw. $\underline{I}_{A,Ph3}$ und die Phase-Erde-Spannungszeiger mit den Bezugszeichen $\underline{U}_{A,Ph2-E}$ bzw. $\underline{U}_{A,Ph3-E}$ gekennzeichnet.

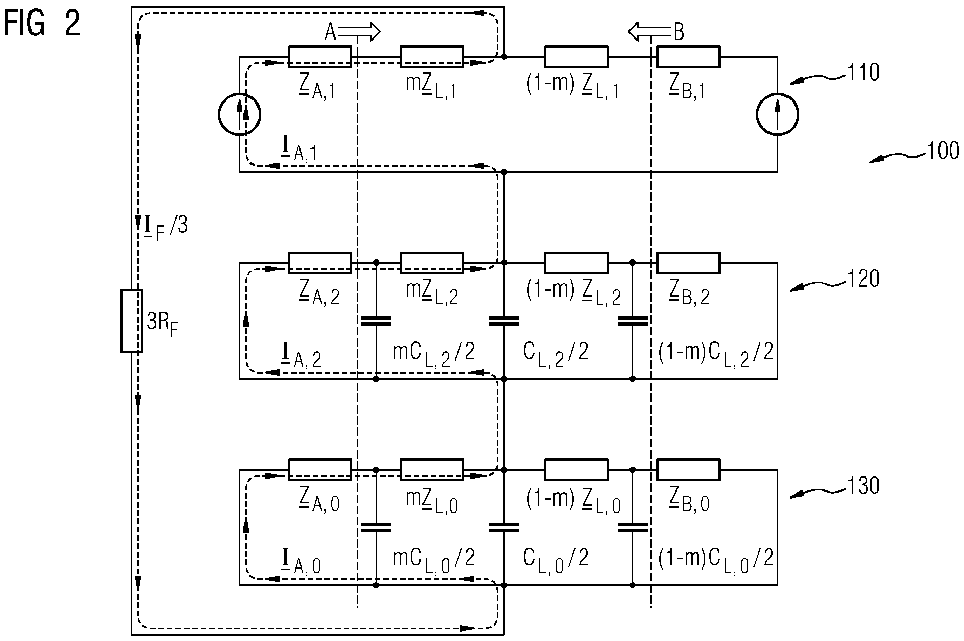

Für die weiteren Berechnungen berücksichtigt das Schutzgerät 40 ein systemkomponentenbezogenes Ersatzschaltbild 100, das beispielhaft in der Figur 2 gezeigt ist. Das systemkomponentenbezogene Ersatzschaltbild 100 umfasst ein Mitsystem 110, ein Gegensystem 120 sowie ein Nullsystem 130, wie sie prinzipiell beispielsweise aus der eingangs genannten Druckschrift (vgl. insbesondere Figur 2 dieser Druckschrift) bekannt und dort beschrieben sind. Zusätzlich und im Unterschied zu dem vorbekannten Ersatzschaltbild umfasst das systemkomponentenbezogene Ersatzschaltbild 100 gemäß Figur 2 Kapazitätseffekte durch zusätzliche Berücksichtigung eines Nullsystemkapazitätswerts $C_{0,L}$ und eines Gegensystemkapazitätswerts $C_{2,L}$, die weiter unten noch näher erläutert werden.

Auf der Basis der Methode der symmetrischen Komponenten kann das Schutzgerät 40 gemäß einer ersten als besonders vorteilhaft angesehenen Verfahrensvariante für das Ersatzschaltbild 100 einen nullsystembezogenen Kompensationsstromzeiger $\underline{I}_{A,Cmp}$ berechnen gemäß:

$$\underline{I}_{A,Cmp} = 3 \cdot (\underline{I}_{A,O} - KW)$$

wobei $\underline{I}_{A,0}$ einen Nullsystemstromzeiger an der Messstelle bzw. dem linken Abschnittsende A und KW einen (hier nullsystembezogenen Korrekturwert) bezeichnet.

Die Berechnung des Nullsystemstromzeigers $\underline{I}_{A,0}$ und des Nullsystemspannungszeigers $\underline{U}_{A,0}$ für die Messstelle bzw. das linke Abschnittsende A erfolgt in bekannter Weise.

Der Korrekturwert KW wird bei der ersten Verfahrensvariante vorzugsweise ermittelt gemäß

$$KW = j\omega \cdot C_{0,L} \cdot \underline{U}_{A,0}$$

wobei $C_{0,L}$ den Nullsystemkapazitätswert des Leitungsabschnitts 30 und $\omega$ die Kreisfrequenz des dreiphasigen Energieübertragungssystems bezeichnet.

Der Nullsystemkapazitätswert $C_{0,L}$ kann anhand von phasenleiterbezogenen Kapazitätswerten, die gemessen oder auf der Basis von geometrischen Leitungsangaben berechnet worden sind, und auf der Basis der Methode der symmetrischen Komponenten errechnet werden; auch dies ist allgemein bekannt.

Anschließend errechnet das Schutzgerät 40 eine Impedanz Zf, die hier als Fehlerimpedanz bezeichnet wird, da sie zur Überprüfung, ob ein Fehler tatsächlich vorliegt oder nicht, herangezogen wird. Die Berechnung der Fehlerimpedanz Zf erfolgt vorzugsweise wie folgt:

$$\underline{Z}_F \;=\; R_F \;+\; j \; X_F$$

mit

$$X_F = \frac{\sin \varphi \cdot \mathrm{Im}\!\left[\underline{U}_{A,Ph-E} \cdot I_{A,Cmp}^{*} \cdot \underline{\delta}_{A,B}^{*}\right]}{\mathrm{Im}\!\left[e^{j\varphi} \cdot \left(\underline{I}_{A,Ph} - \underline{k}_0 \cdot \underline{I}_{A,E}\right) \cdot \underline{I}_{A,Cmp}^{*} \cdot \underline{\delta}_{A,B}^{*}\right]}$$

$$R_F = \frac{\mathrm{Im}\!\left[\underline{U}_{A,Ph-E} \cdot e^{-j\varphi} \cdot \left(\underline{I}_{A,Ph} - \underline{k}_0 \cdot \underline{I}_{A,E}\right)^{*}\right]}{\mathrm{Im}\!\left[\underline{I}_{A,Cmp} \cdot \underline{\delta}_{A,B} \cdot e^{-j\varphi} \cdot \underline{I}_{A,Ph}^{*}\right]}$$

wobei $R_F$ den Realteil der Fehlerimpedanz, $X_2$ den Imaginärteil der Fehlerimpedanz, $\varphi$ den Leitungswinkel des Leitungsabschnitts 30 bzw. den Zeigerwinkel der Leitungsimpedanz des Leitungsabschnitts 30, $\underline{\delta}_{A,B}$ einen Kompensationsfaktor, $\underline{I}_{A,E}$ einen Erdstromzeiger und $\underline{k}_0$ einen Erdkompensationsfaktor bezeichnet. Das Zeichen "*" markiert die komplexe Konjugation des jeweiligen komplexen Zeigers.

Der Erdkompensationsfaktor $\underline{k}_0$ kann auch als Erdimpedanzanpassungsfaktor bezeichnet werden und wird beispielsweise berechnet durch Division der komplexen Erdimpedanz $\underline{Z}_E$ durch die komplexe Leitungsimpedanz Z.

Der Kompensationsfaktor $\underline{\delta}_{A,B}$ wird vorzugsweise wie folgt berechnet:

$$\underline{\delta}_{A,B} = \left(\frac{\underline{Z}_{A,0} + m \cdot \underline{Z}_{L,0}}{(1-m) \cdot \underline{Z}_{L,0} + \underline{Z}_{B,0}} + 1\right)$$

wobei $\underline{Z}_{A,0}$ die Nullsystemimpedanz im Nullsystem 130 an dem linken Abschnittsende A, $\underline{Z}_{B,0}$ die Nullsystemimpedanz im Nullsystem an dem anderen, in der Figur 1 rechten Abschnittsende B des Leitungsabschnitts 31, m die angenommene relative Fehlerentfernung von dem linken Abschnittsende A und $\underline{Z}_{L,0}$ die Leitungsimpedanz im Nullsystem 130 bezeichnet. Die genannten Impedanzen können in bekannterweise Weise unter Einbezug der Methode der symmetrischen Komponenten, insbesondere unter Einbezug von phasenleiterbezogenen Widerstandsbelägen, Kapazitäts- und Induktivitätsbelägen und der Abschnittslänge und/oder auf der Basis von geometrischen Leitungsangaben berechnet werden, wie dies allgemein bekannt ist.

Liegt die Fehlerimpedanz Zf vor, so kann geprüft werden, ob diese in der komplexen Ebene in einem oder mehreren vorgegebenen Fehlergebieten liegt oder nicht. Ist dies der Fall, so schließt das Schutzgerät 40 auf das Vorliegen eines Erdschlusses des Phasenleiters 31 und erzeugt ein entsprechendes Fehlersignal FE31.

Alternativ oder zusätzlich kann das Schutzgerät 40 gemäß einer zweiten als besonders vorteilhaft angesehenen Verfahrensvariante den Kompensationsstromzeiger $\underline{I}_{A,Cmp}$ und den Korrekturwert KW gegensystembezogen berechnen gemäß:

$$\underline{I}_{A,Cmp} = 3 \cdot \left(\underline{I}_{A,2} - KW\right)$$

wobei $\underline{I}_{A,2}$ einen Gegensystemstromzeiger an der Messstelle bzw. dem linken Abschnittsende A bezeichnet. Die Berechnung des Gegensystemstromzeigers $\underline{I}_{A,2}$ erfolgt in bekannter Weise.

Der Korrekturwert wird gegensystembezogen vorzugsweise ermittelt gemäß

$$KW = j\omega \cdot C_{2,L} \cdot \underline{U}_{A,2}$$

wobei $C_{2,L}$ den Gegensystemkapazitätswert des Leitungsabschnitts 30, KW den gegensystembezogen Korrekturwert und $\underline{U}_{3,2}$ den Gegensystemspannungszeiger an der Messstelle bzw. dem linken Abschnittsende A bezeichnet.

Der Kompensationsfaktor $\underline{\delta}_{A,B}$ wird dann ebenfalls gegensystembezogen errechnet gemäß

$$\underline{\delta}_{A,B} = \left(\frac{\underline{Z}_{A,2} + m \cdot \underline{Z}_{L,2}}{(1-m) \cdot \underline{Z}_{L,2} + \underline{Z}_{B,2}} + 1\right)$$

wobei $\underline{Z}_{A,2}$ die Gegensystemimpedanz der Leitungsimpedanz des Leitungsabschnitts 30 an der Messstelle bzw. dem

Abschnittsende A, $\underline{Z}_{B,2}$ die Gegensystemimpedanz der Leitungsimpedanz des Leitungsabschnitts 30 an dem anderen, rechten Leitungsende B des Leitungsabschnitts 30 und m die angenommene relative Fehlerentfernung von der Messstelle bzw. dem linken Abschnittsende A bezeichnet.

Gegensystembezogen wird die Fehlerimpedanz vorzugsweise genauso berechnet wie nullstrombezogen, also gemäß

$$\underline{Z}_F = R_F + j\ X_F$$

mit

$$X_F = \frac{\sin\varphi \cdot \text{Im}\left[\underline{U}_{A,Ph-E} \cdot I_{A,Cmp}^* \cdot \underline{\delta}_{A,B}^*\right]}{\text{Im}\left[e^{j\varphi} \cdot \left(\underline{I}_{A,Ph} - \underline{k}_0 \cdot \underline{I}_{A,E}\right) \cdot \underline{I}_{A,Cmp}^* \cdot \underline{\delta}_{A,B}^*\right]}$$

$$R_F = \frac{\text{Im}\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\text{Im}\left[\underline{I}_{A,Cmp} \cdot \underline{\delta}_{A,B} \cdot e^{-j\varphi} \cdot \underline{I}_{A,Ph}^*\right]}$$

Liegt die gegensystembezogene Fehlerimpedanz Zf vor, so kann wieder geprüft werden, ob diese in der komplexen Ebene in einem oder mehreren vorgegebenen Fehlergebieten liegt oder nicht. Ist dies der Fall, so schließt das Schutzgerät 40 auf das Vorliegen eines Erdschlusses des Phasenleiters 31 und erzeugt das entsprechende Fehlersignal FE31.

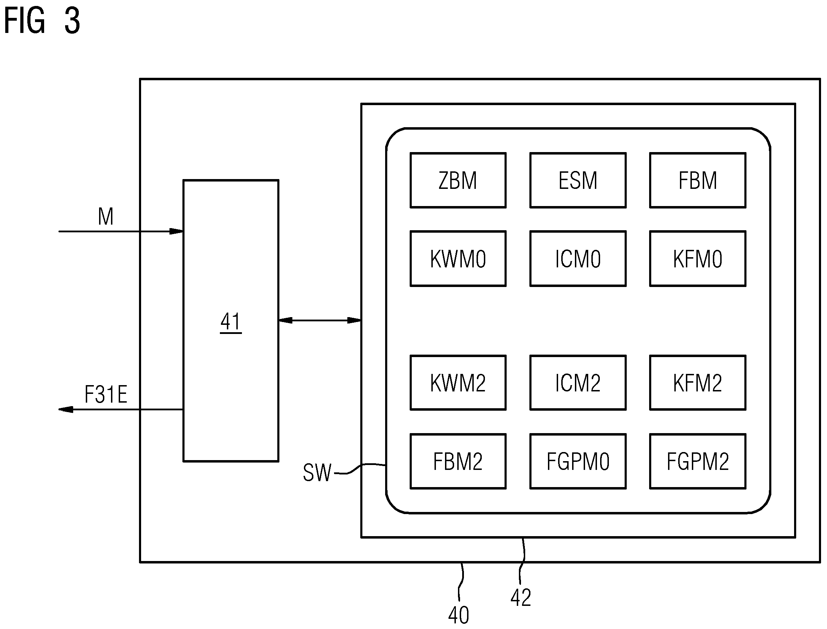

Die Figur 3 zeigt ein Ausführungsbeispiel für ein erfindungsgemäßes Schutzgerät 40. Das Schutzgerät 40 umfasst eine Recheneinrichtung 41 und einen Speicher 42. In dem Speicher 42 ist ein Softwareprogrammprodukt SW abgespeichert, das bei Ausführung durch die Recheneinrichtung 41 die oben im Zusammenhang mit den Figuren 1 und 2 beschriebenen Berechnungsschritte ausführt.

Zu diesem Zwecke umfasst das Softwareprogrammprodukt SW gemäß Figur 3 vorzugsweise ein Zeigerbildungsmodul ZBM zur Bildung der Phasenstromzeiger $I_{A,Ph}$, $I_{A,Ph2}$ und $I_{A,Ph3}$ und der Phase-Erde-Spannungszeiger $\underline{U}_{A,Ph-E}$ $\underline{U}_{A,Ph2-E}$ und $\underline{U}_{A,Ph3-E}$ anhand von Abtastwerten, die auf der Basis der Messsignale bzw. Messwerte M der Strom- und Spannungswandler 61, 62 und 63 erzeugt werden oder in diesen bereits enthalten sind.

Außerdem umfasst das Softwareprogrammprodukt SW gemäß Figur 3 vorzugsweise ein Ersatzschaltbildmodul ESM zur Ermittlung und Berücksichtigung des systemkomponentenbezogenen Ersatzschaltbilds 100 gemäß Figur 2.

Außerdem umfasst das Softwareprogrammprodukt SW gemäß Figur 3 vorzugsweise ein Korrekturwertmodul KWM0 zur Ermittlung des nullsystembezogenen Korrekturwerts KW gemäß

$$KW = j\omega \cdot C_{0,L} \cdot \underline{U}_{A,0}$$

Außerdem umfasst das Softwareprogrammprodukt SW gemäß Figur 3 vorzugsweise ein nullsystembezogenes Kompensationsstrommodul ICMO zur Berechnung des nullsystembezogenen Kompensationsstromzeigers $I_{A,Cmp}$ gemäß

$$\underline{I}_{A,Cmp} = 3 \cdot \left(\underline{I}_{A,O} - j\omega \cdot C_{0,L} \cdot \underline{U}_{A,0}\right)$$

Außerdem umfasst das Softwareprogrammprodukt SW gemäß Figur 3 vorzugsweise ein nullsystembezogenes Kompensationsfaktormodul KFMO zur Berechnung eines Kompensationsfaktors gemäß

$$\underline{\delta}_{A,B} = \left(\frac{\underline{Z}_{A,2} + m \cdot \underline{Z}_{L,2}}{(1-m) \cdot \underline{Z}_{L,2} + \underline{Z}_{B,2}} + 1\right)$$

Außerdem umfasst das Softwareprogrammprodukt SW gemäß Figur 3 vorzugsweise ein Fehlerzeigerberechnungsmodul FBM zur Berechnung einer nullsystembezogenen Fehlerimpedanz Zf gemäß

$$\underline{Z}_F = R_F + j\ X_F$$

mit

$$X_F = \frac{\sin\varphi \cdot \mathrm{Im}\left[\underline{U}_{A,Ph-E} \cdot \underline{I}_{A,Cmp}^* \cdot \underline{\delta}_{A,B}^*\right]}{\mathrm{Im}\left[e^{j\varphi} \cdot \left(\underline{I}_{A,Ph} - \underline{k}_0 \cdot \underline{I}_{A,E}\right) \cdot \underline{I}_{A,Cmp}^* \cdot \underline{\delta}_{A,B}^*\right]}$$

$$R_F = \frac{\mathrm{Im}\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\mathrm{Im}\left[\underline{I}_{A,Cmp} \cdot \underline{\delta}_{A,B} \cdot e^{-j\varphi} \cdot \underline{I}_{A,Ph}^*\right]}$$

Außerdem umfasst das Softwareprogrammprodukt SW gemäß Figur 3 vorzugsweise ein Fehlergebietprüfungsmodul FGPM0 zur Prüfung, ob die nullsystembezogene Fehlerimpedanz Zf in der komplexen Ebene in einem oder mehreren vorgegebenen Fehlergebieten liegt oder nicht, und zur Erzeugung eines entsprechendes Fehlersignals FE31.

Außerdem umfasst das Softwareprogrammprodukt SW gemäß Figur 3 vorzugsweise ein Korrekturwertmodul KWM2 zur Ermittlung des gegensystembezogenen Korrekturwerts KW gemäß

$$KW = j\omega \cdot C_{0,L} \cdot \underline{U}_{A,0}$$

Außerdem umfasst das Softwareprogrammprodukt SW gemäß Figur 3 vorzugsweise ein gegensystembezogenes Kompensationsstrommodul ICM2 zur Berechnung des gegensystembezogenen Kompensationsstromzeigers $\underline{I}_{A,Cmp}$ gemäß

$$\underline{I}_{A,Cmp} = 3 \cdot \left(\underline{I}_{A,2} - j\omega \cdot C_{2,L} \cdot \underline{U}_{A,2}\right)$$

Außerdem umfasst das Softwareprogrammprodukt SW gemäß Figur 3 vorzugsweise ein gegensystembezogenes Kompensationsfaktormodul KFM2 zur Berechnung eines gegensystembezogenen Kompensationsfaktors gemäß

$$\underline{\delta}_{A,B} = \left(\frac{\underline{Z}_{A,2} + m \cdot \underline{Z}_{L,2}}{(1-m) \cdot \underline{Z}_{L,2} + \underline{Z}_{B,2}} + 1\right)$$

Das Softwareprogrammprodukt SW gemäß Figur 3 kann ein gesondertes Fehlerzeigerberechnungsmodul FBM2 zur Berechnung einer gegensystembezogenen Fehlerimpedanz aufweisen; alternativ kann die Berechnung der gegensystembezogenen Fehlerimpedanz von dem Fehlerzeigerberechnungsmodul FBM durchgeführt werden, das auch die Berechnung der nullsystembezogenen Fehlerimpedanz durchführt.

Außerdem umfasst das Softwareprogrammprodukt SW gemäß Figur 3 vorzugsweise ein Fehlergebietprüfungsmodul FGPM2 zur Prüfung, ob die gegensystembezogene Fehlerimpedanz in der komplexen Ebene in einem oder mehreren vorgegebenen Fehlergebieten liegt oder nicht, und zur Erzeugung eines entsprechendes Fehlersignals FE31.

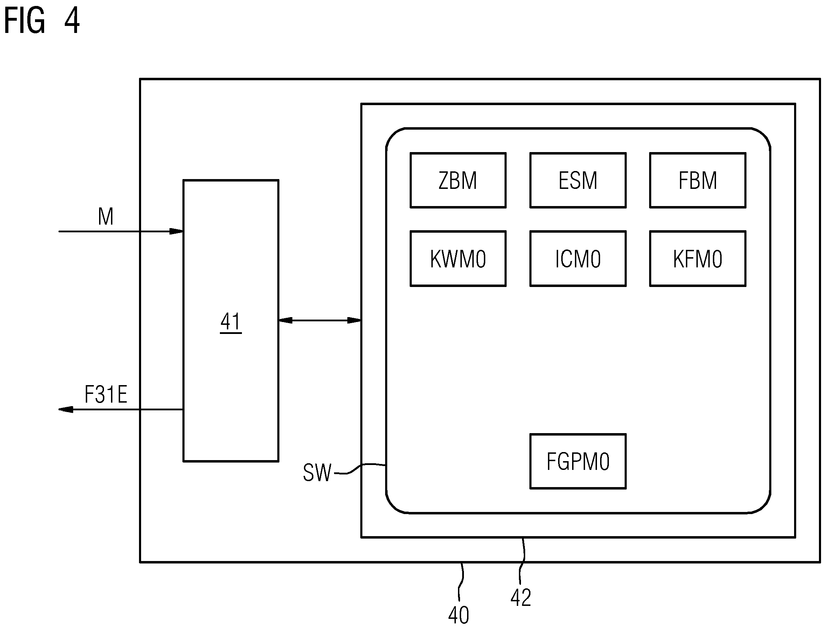

Die Figur 4 zeigt ein weiteres Ausführungsbeispiel für ein erfindungsgemäßes Schutzgerät 40. Bei dem Schutzgerät 40 gemäß Figur 4 wird die Erdschlussprüfung nur nullsystembezogen durchgeführt, so dass auch nur die diesbezüglichen Softwaremodule vorhanden sind, wie sie oben bereits im Zusammenhang mit der Figur 3 erläutert worden sind.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden, solange diese unter den Schutzumfang der angehängten Ansprüche fallen.

## Patentansprüche

1. Verfahren zum Erkennen eines einphasigen Erdschlusses eines elektrischen Phasenleiters (31) in einem Leitungsabschnitt (30) einer dreiphasigen elektrischen Energieübertragungsleitung, wobei bei dem Verfahren

   - an einer an einem Abschnittsende (A) des Leitungsabschnitts (30) befindlichen Messstelle für den Phasenleiter (31) Phasenstrom und Phase-Erde-Spannung unter Bildung eines Phasenstromzeigers ($\underline{I}_{A,Ph}$) und eines Phasenspannungszeigers ($\underline{U}_{A,Ph}$) gemessen werden,
   - unter Berücksichtigung des Phasenstromzeigers und des Phasenspannungszeigers und eines Kompensationsstromzeigers eine Fehlerimpedanz errechnet wird und
- anhand der Fehlerimpedanz auf das Vorliegen oder Nichtvorliegen eines Erdschlusses des Phasenleiters (31) geschlossen wird,

**dadurch gekennzeichnet, dass**

- der Kompensationsstromzeiger in Abhängigkeit von einem Korrekturwert, dessen Berechnung eine Multiplikation eines die Kapazität des Leitungsabschnitts (30) angebenden Kapazitätswerts und eines Bezugsspannungszeigers einschließt, errechnet wird, wobei
- auf der Basis der Methode der symmetrischen Komponenten ein den Nullsystemstrom (130) an der Messstelle angebender Nullsystemstromzeiger ($\underline{I}_{A,0}$) errechnet wird, und der Kompensationsstromzeiger unter Einbezug des Nullsystemstromzeigers ($\underline{I}_{A,0}$) errechnet wird und wobei
- der Kompensationsstromzeiger durch Subtraktion des Korrekturwerts von einem Vielfachen des Nullsystemstromzeigers ($\underline{I}_{A,0}$) errechnet wird, oder wobei
- auf der Basis der Methode der symmetrischen Komponenten ein die Gegensystemspannung an der Messstelle angebender Gegensystemspannungszeiger ($\underline{U}_{A,2}$) errechnet wird,
- zur Berechnung des Korrekturwerts als der genannte Kapazitätswert ein die Gegensystemkapazität des Leitungsabschnitts (30) angebender Gegensystemkapazitätswert ($C_{2,L}$) herangezogen wird und
- zur Berechnung des Korrekturwerts als der genannte Bezugsspannungszeiger der Gegensystemspannungszeiger herangezogen wird.

2. Verfahren nach Anspruch 1,
**dadurch gekennzeichnet, dass**
die Berechnung des Kompensationsstromzeigers eine Multiplikation des die Kapazität des Leitungsabschnitts (30) angebenden Kapazitätswerts, des Bezugsspannungszeigers und der Drehfrequenz der elektrischen Energieübertragungsleitung einschließt.

3. Verfahren nach einem der voranstehenden Ansprüche,
**dadurch gekennzeichnet, dass**

- auf der Basis der Methode der symmetrischen Komponenten ein die Nullsystemspannung an der Messstelle angebender Nullsystemspannungszeiger errechnet wird,
- zur Berechnung des Korrekturwerts als der genannte Kapazitätswert ein die Nullsystemkapazität des Leitungsabschnitts (30) angebender Nullsystemkapazitätswert ($C_{0,L}$) herangezogen wird und
- zur Berechnung des Korrekturwerts als der genannte Bezugsspannungszeiger der Nullsystemspannungszeiger herangezogen wird.

4. Verfahren nach Anspruch 3,
**dadurch gekennzeichnet, dass**

der Korrekturwert berechnet wird gemäß:

$$KW = j\omega \cdot C_{0,L} \cdot \underline{U}_{A,0}$$

wobei $C_{0,L}$ den Nullsystemkapazitätswert des Leitungsabschnitts (30), KW den Korrekturwert und $\underline{U}_{A,0}$ den Nullsystemspannungszeiger bezeichnet.

5. Verfahren nach einem der voranstehenden Ansprüche,
**dadurch gekennzeichnet, dass**

der Kompensationsstromzeiger berechnet wird gemäß:

$$\underline{I}_{A,Cmp} = 3 \cdot (\underline{I}_{A,O} - j\omega \cdot C_{0,L} \cdot \underline{U}_{A,0})$$

wobei $\underline{I}_{A,Cmp}$ den Kompensationsstromzeiger, $\underline{I}_{A,0}$ den Nullsystemstromzeiger an der Messstelle, $C_{0,L}$ den Nullsystemkapazitätswert des Leitungsabschnitts (30), KW den Korrekturwert und $\underline{U}_{A,0}$ den Nullsystemspannungszeiger bezeichnet.

6. Verfahren nach Anspruch 5,

**dadurch gekennzeichnet, dass**

ein Kompensationsfaktor errechnet wird gemäß

$$\underline{\delta}_{A,B} = \left( \frac{\underline{Z}_{A,0} + m \cdot \underline{Z}_{L,0}}{(1-m) \cdot \underline{Z}_{L,0} + \underline{Z}_{B,0}} + 1 \right)$$

wobei $\underline{\delta}_{A,B}$ den Kompensationsfaktor, $\underline{Z}_{A,0}$ die Nullsystemimpedanz des Leitungsabschnitts (30) an der Mess-stelle, $\underline{Z}_{B,0}$ die Nullsystemimpedanz des Leitungsabschnitts (30) an dem anderen Leitungsende des Leitungsabschnitts (30) und m die relative Fehlerentfernung von der Messstelle bezeichnet.

7. Verfahren nach Anspruch 1,
**dadurch gekennzeichnet, dass**

der Korrekturwert berechnet wird gemäß:

$$KW = j\omega \cdot C_{2,L} \cdot \underline{U}_{A,2}$$

wobei $C_{2,L}$ den Gegensystemkapazitätswert des Leitungsabschnitts (30), KW den Korrekturwert und $\underline{U}_{A,2}$ den Gegensystemspannungszeiger bezeichnet.

8. Verfahren nach Anspruch 7,
**dadurch gekennzeichnet, dass**

der Kompensationsstromzeiger berechnet wird gemäß:

$$\underline{I}_{A,Cmp} = 3 \cdot (\underline{I}_{A,2} - j\omega \cdot C_{2,L} \cdot \underline{U}_{A,2})$$

wobei $\underline{I}_{A,Cmp}$ den Kompensationsstrom, $\underline{I}_{A,2}$ den Gegensystemstrom an der Messstelle, $C_{2,L}$ den Gegensystemkapazitätswert des Leitungsabschnitts (30) und KW den Korrekturwert bezeichnet.

9. Verfahren nach Anspruch 8,
**dadurch gekennzeichnet, dass**

ein Kompensationsfaktor errechnet wird gemäß

$$\underline{\delta}_{A,B} = \left( \frac{\underline{Z}_{A,2} + m \cdot \underline{Z}_{L,2}}{(1-m) \cdot \underline{Z}_{L,2} + \underline{Z}_{B,2}} + 1 \right)$$

wobei $\underline{\delta}_{A,B}$ den Kompensationsfaktor, $\underline{Z}_{A,2}$ die Gegensystemimpedanz des Leitungsabschnitts (30) an der Messstelle, $\underline{Z}_{B,2}$ die Gegensystemimpedanz des Leitungsabschnitts (30) an dem anderen Leitungsende des Leitungsabschnitts (30) und m die relative Fehlerentfernung von der Messstelle bezeichnet.

10. Verfahren nach einem der voranstehenden Ansprüche,
**dadurch gekennzeichnet, dass**

die Fehlerimpedanz berechnet wird gemäß

$$\underline{Z}_F = R_F + j\ X_F$$

mit

$$X_F = \frac{\sin\varphi \cdot \mathrm{Im}\!\left[\underline{U}_{A,Ph-E} \cdot \underline{I}^*_{A,Cmp} \cdot \underline{\delta}^*_{A,B}\right]}{\mathrm{Im}\!\left[e^{j\varphi} \cdot \left(\underline{I}_{A,Ph} - \underline{k}_0 \cdot \underline{I}_{A,E}\right) \cdot \underline{I}^*_{A,Cmp} \cdot \underline{\delta}^*_{A,B}\right]}$$

$$R_F = \frac{\mathrm{Im}\!\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\mathrm{Im}\!\left[\underline{I}_{A,Cmp} \cdot \underline{\delta}_{A,B} \cdot e^{-j\varphi} \cdot \underline{I}^*_{A,Ph}\right]}$$

wobei $\underline{Z}_F$ die Fehlerimpedanz, $R_F$ den Realteil der Fehlerimpedanz, $X_2$ den Imaginärteil der Fehlerimpedanz, $\varphi$, $\underline{I}_{A,Cmp}$ den Kompensationsstrom, $\underline{\delta}_{A,B}$ einen Kompensationsfaktor, $\underline{U}_{A,Ph\text{-}E}$ den Phasenspannungszeiger, $\underline{I}_{A,Ph}$ den Phasenstromzeiger, $\underline{I}_{A,E}$ einen Erdstromzeiger und $k_0$ einen Erdkompensationsfaktor bezeichnen.

11. Verfahren nach einem der voranstehenden Ansprüche,
**dadurch gekennzeichnet, dass**
das Verfahren bei einer dreiphasigen elektrischen Energieübertragungsleitung eingesetzt wird, bei der der Sternpunkt über eine Impedanz geerdet ist.

12. Schutzgerät (40) zum Erkennen eines einphasigen Erdschlusses eines elektrischen Phasenleiters (31) in einem Leitungsabschnitt (30) einer dreiphasigen elektrischen Energieübertragungsleitung, wobei das Schutzgerät (40) dazu ausgestaltet ist,

- für ein Abschnittsende (A) des Leitungsabschnitts (30) für den Phasenleiter (31) Phasenstrom und Phase-Erde-Spannung unter Bildung eines Phasenstromzeigers und eines Phasenspannungszeigers zu erfassen,
- unter Berücksichtigung des Phasenstromzeigers und des Phasenspannungszeigers und eines Kompensationsstromzeigers eine Fehlerimpedanz zu errechnen und
- anhand der Fehlerimpedanz auf das Vorliegen oder Nichtvorliegen eines Erdschlusses des Phasenleiters (31) zu schließen,
**dadurch gekennzeichnet, dass**
das Schutzgerät (40) derart ausgestaltet ist, dass es den Kompensationsstromzeiger in Abhängigkeit von einem Korrekturwert errechnet, dessen Berechnung eine Multiplikation eines die Kapazität des Leitungsabschnitts (30) angebenden Kapazitätswerts und eines Bezugsspannungszeigers einschließt, wobei von dem Schutzgerät
- auf der Basis der Methode der symmetrischen Komponenten ein den Nullsystemstrom (130) an einer Messstelle angebender Nullsystemstromzeiger errechnet wird, und der Kompensationsstromzeiger unter Einbezug des Nullsystemstromzeigers errechnet wird und wobei
- der Kompensationsstromzeiger durch Subtraktion des Korrekturwerts von einem Vielfachen des Nullsystemstromzeigers errechnet wird, oder wobei von dem Schutzgerät
- auf der Basis der Methode der symmetrischen Komponenten ein die Gegensystemspannung an der Messstelle angebender Gegensystemspannungszeiger errechnet wird,
- zur Berechnung des Korrekturwerts als der genannte Kapazitätswert ein die Gegensystemkapazität des Leitungsabschnitts (30) angebender Gegensystemkapazitätswert herangezogen wird und
- zur Berechnung des Korrekturwerts als der genannte Bezugsspannungszeiger der Gegensystemspannungszeiger herangezogen wird.

## Claims

1. Method for detecting a single-phase earth fault of an electrical phase conductor (31) in a line section (30) of a three-phase electrical power transmission line, wherein, in the method,

- phase current and phase-earth voltage are measured at a measuring point for the phase conductor (31) at a section end (A) of the line section (30) so as to form a current phase vector ($\underline{I}_{A,Ph}$) and a voltage phase vector ($\underline{U}_{A,Ph}$),
- a fault impedance is calculated taking into account the current phase vector and the voltage phase vector and a compensation current vector, and
- the fault impedance is used to infer the presence or absence of an earth fault of the phase conductor (31),
**characterized in that**
- the compensation current vector is calculated as a function of a correction value, the calculation of which includes a multiplication of a capacitance value indicating the capacitance of the line section (30) and a reference voltage vector, wherein

- a negative phase-sequence system current vector ($\underline{I}_{A,0}$) indicating the negative phase-sequence system current (130) at the measuring point is calculated based on the symmetrical component method, and the compensation current vector is calculated taking into account the negative phase-sequence system current vector ($\underline{I}_{A,0}$), and wherein

- the compensation current vector is calculated by subtracting the correction value from a multiple of the negative phase-sequence system current vector ($\underline{I}_{A,0}$), or wherein

- a positive phase-sequence system voltage vector ($\underline{U}_{A,2}$) indicating the positive phase-sequence system voltage at the measuring point is calculated based on the symmetrical component method,

- a positive phase-sequence system capacitance value ($C_{2,L}$) indicating the positive phase-sequence system capacitance of the line section (30) is used to calculate the correction value as said capacitance value, and

- the positive phase-sequence system voltage vector is used to calculate the correction value as said reference voltage vector.

2. Method according to Claim 1,
   **characterized in that**
   the calculation of the compensation current vector includes a multiplication of the capacitance value indicating the capacitance of the line section (30), the reference voltage vector and the rotational frequency of the electrical power transmission line.

3. Method according to either one of the preceding claims, **characterized in that**

   - a negative phase-sequence system voltage vector indicating the negative phase-sequence system voltage at the measuring point is calculated based on the symmetrical component method,
   - a negative phase-sequence system capacitance value ($C_{0,L}$) indicating the negative phase-sequence system capacitance of the line section (30) is used to calculate the correction value as said capacitance value, and
   - the negative phase-sequence system voltage vector is used to calculate the correction value as said reference voltage vector.

4. Method according to Claim 3,
   **characterized in that**

   the correction value is calculated according to:

   $$KW = j\omega \cdot C_{0,L} \cdot \underline{U}_{A,0}$$

   where $C_{0,L}$ denotes the negative phase-sequence system capacitance value of the line section (30), KW denotes the correction value and $\underline{U}_{A,0}$ denotes the negative phase-sequence system voltage vector.

5. Method according to any one of the preceding claims,
   **characterized in that**

   the compensation current vector is calculated according to:

   $$\underline{I}_{A,Cmp} = 3 \cdot (\underline{I}_{A,O} - j\omega \cdot C_{0,L} \cdot \underline{U}_{A,0})$$

   where $\underline{I}_{A,Cmp}$ denotes the compensation current vector, $\underline{I}_{A,0}$ denotes the negative phase-sequence system current vector at the measuring point, $C_{0,L}$ denotes the negative phase-sequence system capacitance value of the line section (30), KW denotes the correction value and $\underline{U}_{A,0}$ denotes the negative phase-sequence system voltage vector.

6. Method according to Claim 5,
   **characterized in that**

   a compensation factor is calculated according to

$$\underline{\delta}_{A,B} = \left( \frac{\underline{Z}_{A,0} + m \cdot \underline{Z}_{L,0}}{(1-m) \cdot \underline{Z}_{L,0} + \underline{Z}_{B,0}} + 1 \right)$$

where $\underline{\delta}_{A,B}$ denotes the compensation factor, $\underline{Z}_{A,0}$ denotes the negative phase-sequence system impedance of the line section (30) at the measuring point, $\underline{Z}_{B,0}$ denotes the negative phase-sequence system impedance of the line section (30) at the other line end of the line section (30) and m denotes the relative distance of the fault from the measuring point.

7. Method according to Claim 1,
   **characterized in that**

   the correction value is calculated according to:

$$KW = j\omega \cdot C_{2,L} \cdot \underline{U}_{A,2}$$

   where $C_{2,L}$ denotes the positive phase-sequence system capacitance value of the line section (30), KW denotes the correction value and $\underline{U}_{A,2}$ denotes the positive phase-sequence system voltage vector.

8. Method according to Claim 7,
   **characterized in that**

   the compensation current vector is calculated according to:

$$\underline{I}_{A,Cmp} = 3 \cdot (\underline{I}_{A,2} - j\omega \cdot C_{2,L} \cdot \underline{U}_{A,2})$$

   where $\underline{I}_{A,Cmp}$ denotes the compensation current, $\underline{I}_{A,2}$ denotes the positive phase-sequence system current at the measuring point, $C_{2,L}$ denotes the positive phase-sequence system capacitance value of the line section (30) and KW denotes the correction value.

9. Method according to Claim 8,
   **characterized in that**

   a compensation factor is calculated according to

$$\underline{\delta}_{A,B} = \left( \frac{\underline{Z}_{A,2} + m \cdot \underline{Z}_{L,2}}{(1-m) \cdot \underline{Z}_{L,2} + \underline{Z}_{B,2}} + 1 \right)$$

   where $\underline{\delta}_{A,B}$ denotes the compensation factor, $\underline{Z}_{A,2}$ denotes the positive phase-sequence system impedance of the line section (30) at the measuring point, $\underline{Z}_{B,2}$ denotes the positive phase-sequence system impedance of the line section (30) at the other line end of the line section (30) and m denotes the relative distance of the fault from the measuring point.

10. Method according to any one of the preceding claims,
    **characterized in that**

    the fault impedance is calculated according to

$$\underline{Z}_F = R_F + j\ X_F$$

    with

$$X_F = \frac{\sin\varphi \cdot \mathrm{Im}\left[\underline{U}_{A,Ph-E} \cdot I^*_{A,Cmp} \cdot \underline{\delta}^*_{A,B}\right]}{\mathrm{Im}\left[e^{j\varphi} \cdot \left(\underline{I}_{A,Ph} - \underline{k}_0 \cdot \underline{I}_{A,E}\right) \cdot \underline{I}^*_{A,Cmp} \cdot \underline{\delta}^*_{A,B}\right]}$$

$$R_F = \frac{\mathrm{Im}\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\mathrm{Im}\left[\underline{I}_{A,Cmp} \cdot \underline{\delta}_{A,B} \cdot e^{-j\varphi} \cdot \underline{I}^*_{A,Ph}\right]}$$

where $\underline{Z}_F$ denotes the fault impedance, $R_F$ denotes the real part of the fault impedance, $X_F$ denotes the imaginary part of the fault impedance, $\varphi$, $\underline{I}_{A,Cmp}$ denotes the compensation current, $\underline{\delta}_{A,B}$ denotes a compensation factor, $\underline{U}_{A,Ph-E}$ denotes the voltage phase vector, $\underline{I}_{A,Ph}$ denotes the current phase vector, $\underline{I}_{A,E}$ denotes an earth current vector and $\underline{k}_0$ denotes an earth compensation factor.

11. Method according to any one of the preceding claims,
**characterized in that**
the method is used in a three-phase electrical power transmission line in which the neutral point is earthed via an impedance.

12. Protective device (40) for detecting a single-phase earth fault in an electrical phase conductor (31) in a line section (30) of a three-phase electrical power transmission line, wherein the protective device (40) is designed

- to detect phase current and phase-earth voltage for the phase conductor (31) for a section end (A) of the line section (30) so as to form a current phase vector and a voltage phase vector,
- to calculate a fault impedance taking into account the current phase vector and the voltage phase vector and a compensation current vector, and
- to use the fault impedance to infer the presence or absence of an earth fault in the phase conductor (31),
**characterized in that**
the protective device (40) is designed in such a way that it calculates the compensation current vector as a function of a correction value, the calculation of which includes a multiplication of a capacitance value indicating the capacitance of the line section (30) and a reference voltage vector, wherein the protective device
- calculates a negative phase-sequence system current vector indicating the negative phase-sequence system current (130) at a measuring point based on the symmetrical component method, and calculates the compensation current vector taking into account the negative phase-sequence system current vector, and wherein
- calculates the compensation current vector by subtracting the correction value from a multiple of the negative phase-sequence system current vector, or wherein the protective device
- calculates a positive phase-sequence system voltage vector indicating the positive phase-sequence system voltage at the measuring point based on the symmetrical component method,
- uses a positive phase-sequence system capacitance value indicating the positive phase-sequence system capacitance of the line section (30) to calculate the correction value as said capacitance value, and
- uses the positive phase-sequence system voltage vector to calculate the correction value as said reference voltage vector.

**Revendications**

1. Procédé d'identification d'un raccordement à la terre monophasé d'un conducteur (31) de phase électrique dans un tronçon (30) d'une ligne triphasée de transport d'énergie électrique, dans lequel dans le procédé

- à un point de mesure, se trouvant à un bout (A) du tronçon (30) de ligne, on mesure, pour le conducteur (31) de phase, un courant de phase et une tension phase - terre avec formation d'un vecteur ($\underline{I}_{A,Ph}$) de courant de phase et d'un vecteur ($\underline{U}_{A,Ph}$) de tension de phase,
- en tenant compte du vecteur de courant de phase et du vecteur de tension de phase et d'un vecteur de courant de compensation, on calcule une impédance d'erreur et
- à l'aide de l'impédance d'erreur, on décide de la présence ou de l'absence d'un raccordement à la terre du conducteur (31) de phase,

**caractérisé en ce qu'**

- on calcule le vecteur de courant de compensation en fonction d'une valeur de correction, dont le calcul inclut une multiplication d'une valeur de capacité indiquant la capacité du tronçon (30) de ligne par un vecteur de tension de référence, dans lequel,
- sur la base de la méthode des composants symétriques, on calcule un vecteur ($I_{A,0}$) de courant de système homopolaire indiquant le courant (130) de système monopolaire au point de mesure, et on calcule le vecteur de courant de compensation en incluant le vecteur ($I_{A,0}$) de courant de système homopolaire et dans lequel
- on calcule le vecteur de courant de compensation en soustrayant la valeur de correction d'un multiple du vecteur ($I_{A,0}$) de courant de système homopolaire, ou dans lequel,
- sur la base de la méthode des composants symétriques, on calcule un vecteur ($U_{A,2}$) de tension de système inverse indiquant la tension de système inverse au point de mesure,
- pour le calcul de la valeur de correction, on tire parti, pour ladite valeur de capacité, d'une valeur ($C_{2,L}$) de capacité de système inverse indiquant la capacité de système inverse du tronçon (30) de ligne, et
- pour le calcul de la valeur de correction, on tire parti, pour ledit vecteur de tension de référence, du vecteur de tension de système inverse.

2. Procédé suivant la revendication 1,
**caractérisé en ce que**
le calcul du vecteur de courant de compensation inclut une multiplication de la valeur de capacité, indiquant la capacité du tronçon (30) de ligne, du vecteur de tension de référence par la fréquence de rotation de la ligne de transport d'énergie électrique.

3. Procédé suivant l'une des revendications précédentes,
**caractérisé en ce que**

- sur la base de la méthode des composants symétriques, on calcule un vecteur de tension de système homopolaire indiquant la tension de système homopolaire au point de mesure,
- pour le calcul de la valeur de correction, on tire parti, pour ladite valeur de capacité, d'une valeur ($C_{0,L}$) de capacité de système homopolaire indiquant la capacité de système homopolaire du tronçon (30) de ligne, et
- pour le calcul de la valeur de correction, on tire parti, pour ledit vecteur de tension de référence, du vecteur de tension de système homopolaire.

4. Procédé suivant la revendication 3,
**caractérisé en ce que**

l'on calcule la valeur de correction suivant :

$$KW = j\omega \cdot C_{0,L} \cdot \underline{U}_{A,0}$$

dans laquelle $C_{0,L}$ désigne la valeur de capacité de système homopolaire du tronçon (30) de ligne, KW la valeur de correction et $\underline{U}_{A,0}$ le vecteur de tension de système homopolaire.

5. Procédé suivant l'une des revendications précédentes,
**caractérisé en ce que**

on calcule le vecteur de courant de compensation suivant :

$$\underline{I}_{A,Cmp} = 3 \cdot (\underline{I}_{A,0} - j\omega \cdot C_{0,L} \cdot \underline{U}_{A,0})$$

dans laquelle $I_{A,Cmp}$ désigne le vecteur de courant de compensation, $\underline{I}_{A,0}$ le vecteur de courant de système homopolaire au point de mesure, $C_{0,L}$ la valeur de capacité de système homopolaire du tronçon (30) de ligne, KW la valeur de correction et $\underline{U}_{A,0}$ le vecteur de tension de système homopolaire.

6. Procédé suivant la revendication 5,
**caractérisé en ce que**

l'on calcule un facteur de compensation suivant

$$\underline{\delta}_{A,B} = \left( \frac{\underline{Z}_{A,0} + m \cdot \underline{Z}_{L,0}}{(1-m) \cdot \underline{Z}_{L,0} + \underline{Z}_{B,0}} + 1 \right)$$

dans laquelle $\underline{\delta}_{A,B}$ désigne le facteur de compensation, $\underline{Z}_{A,0}$ l'impédance de système homopolaire du tronçon (30) de ligne au point de mesure, $\underline{Z}_{B,0}$ l'impédance de système homopolaire du tronçon (30) de ligne à l'autre bout du tronçon (30) de ligne et m l'éloignement relatif de défaut du point de mesure.

**7.** Procédé suivant la revendication 1,
**caractérisé en ce que**

l'on calcule la valeur de correction suivant :

$$KW = j\omega \cdot C_{2,L} \cdot \underline{U}_{A,2}$$

dans laquelle $C_{2,L}$ désigne la valeur de capacité du système inverse du tronçon (30) de ligne, KW la valeur de correction et $\underline{U}_{A,2}$ le vecteur de tension de système inverse.

**8.** Procédé suivant la revendication 7,
**caractérisé en ce que**

l'on calcule le vecteur de courant de compensation suivant :

$$\underline{I}_{A,Cmp} = 3 \cdot (\underline{I}_{A,2} - j\omega \cdot C_{2,L} \cdot \underline{U}_{A,2})$$

dans laquelle $\underline{I}_{A,Cmp}$ désigne le courant de compensation, $\underline{I}_{A,2}$ le courant du système inverse au point de mesure, $C_{2,L}$ la valeur de capacité de système inverse du tronçon (30) de ligne et KW la valeur de correction.

**9.** Procédé suivant la revendication 8,
**caractérisé en ce que**

l'on calcule le facteur de compensation suivant

$$\underline{\delta}_{A,B} = \left( \frac{\underline{Z}_{A,2} + m \cdot \underline{Z}_{L,2}}{(1-m) \cdot \underline{Z}_{L,2} + \underline{Z}_{B,2}} + 1 \right)$$

dans laquelle $\underline{\delta}_{A,B}$ désigne le facteur de compensation, $\underline{Z}_{A,2}$ l'impédance de système inverse du tronçon (30) de ligne au point de mesure, $\underline{Z}_{B,2}$ l'impédance de système inverse du tronçon (30) de ligne à l'autre bout du tronçon (30) de ligne et m l'éloignement relatif de défaut du point de mesure.

**10.** Procédé suivant l'une des revendications précédentes,
**caractérisé en ce que**

l'on calcule l'impédance de défaut suivant

$$\underline{Z}_F = R_F + j \ X_F$$

avec

$$X_F = \frac{\sin\varphi \cdot \mathrm{Im}\left[\underline{U}_{A,Ph-E} \cdot \underline{I}^{\bullet}_{A,Cmp} \cdot \underline{\delta}^{\bullet}_{A,B}\right]}{\mathrm{Im}\left[e^{j\varphi} \cdot (\underline{I}_{A,Ph} - \underline{k}_0 \cdot \underline{I}_{A,E}) \cdot \underline{I}^{\bullet}_{A,Cmp} \cdot \underline{\delta}^{\bullet}_{A,B}\right]}$$

$$R_F = \frac{\text{Im}\left[\underline{U}_{A,Ph-E} \cdot e^{-j\varphi} \cdot \left(\underline{I}_{A,Ph} - \underline{k}_0 \cdot \underline{I}_{A,E}\right)^*\right]}{\text{Im}\left[\underline{I}_{A,Cmp} \cdot \underline{\delta}_{A,B} \cdot e^{-j\varphi} \cdot \underline{I}^*_{A,Ph}\right]}$$

dans lesquelles $\underline{Z}_F$ désigne l'impédance de défaut, $R_F$ la partie réelle de l'impédance de défaut, $X_F$ la partie imaginaire de l'impédance de défaut, $\varphi$, $\underline{I}_{A,Cmp}$ le courant de compensation, $\underline{\delta}_{A,B}$ un facteur de compensation, $\underline{U}_{A,Ph-E}$ le vecteur de tension de phase, $\underline{I}_{A,Ph}$ le vecteur de courant de phase, $\underline{I}_{A,E}$ un vecteur de courant de terre et $\underline{k}_0$ un facteur de compensation de terre.

11. Procédé suivant l'une des revendications précédentes,
**caractérisé en ce que**
l'on utilise le procédé dans une ligne triphasée de transfert d'énergie électrique, dans laquelle le point neutre est mis à la terre par une impédance.

12. Appareil (40) de protection pour l'identification d'un raccordement à la terre monophasé d'un conducteur (31) de phase électrique dans un tronçon (30) d'une ligne triphasée de transport d'énergie électrique, dans lequel l'appareil (40) de protection est conformé :

- pour détecter, pour un bout (A) du tronçon (30) de ligne pour le conducteur (31) de phase, un courant de phase et une tension phase - terre avec formation d'un vecteur de courant de phase et d'un vecteur de phase - tension,
- pour calculer, en tenant compte du vecteur de courant de phase et du vecteur de tension de phase et d'un vecteur de courant de compensation, une impédance de défaut, et
- pour déduire, à l'aide de l'impédance de défaut, la présence ou l'absence d'un raccordement à la terre du conducteur (31) de phase,
**caractérisé en ce que**
l'appareil (40) de protection est conformé de manière à calculer le vecteur de courant de compensation en fonction d'une correction, dont le calcul inclut une multiplication d'une valeur de capacité indiquant la capacité du tronçon (30) de ligne par un vecteur de tension de référence, dans lequel, par l'appareil de protection
- sur la base de la méthode des composants symétriques, on calcule un vecteur de système homopolaire indiquant le courant (130) de système homopolaire en un point de mesure et on calcule le vecteur de courant de compensation en incorporant le vecteur de courant de système homopolaire et dans lequel
- on calcule le vecteur de courant de compensation en soustrayant la valeur de correction d'un multiple du vecteur de courant de système homopolaire, ou dans lequel, par l'appareil de protection,
- sur la base de la méthode des composants symétriques, on calcule un vecteur de tension de système inverse indiquant la tension du système inverse au point de mesure,
- pour le calcul de la valeur de correction, on tire parti, pour ladite valeur de capacité d'une valeur de capacité de système inverse indiquant la capacité de système inverse du tronçon (30) de ligne, et
- pour le calcul de la valeur de correction, pour ledit vecteur de tension de référence, on tire parti du vecteur de tension du système inverse.

FIG 1

EP 4 276 480 B1

FIG 2

EP 4 276 480 B1

EP 4 276 480 B1

FIG 3

EP 4 276 480 B1

FIG 4

M

F31E

41

SW

ZBM   ESM   FBM

KWM0   ICM0   KFM0

FGPM0

40   42

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 60317344 T2
- EP 2738561 A2
- WO O3044547 A1